# EUROPEAN PATENT APPLICATION

(11) **EP 2 019 463 A1**
(43) Date of publication of application: **28.01.2009**
(21) Application number: 08160414.2
(22) Date of filing: 15.07.2008
(51) Int. Cl.: H01S 5/02, H01S 5/14, H01S 5/022, H01S 5/024, H01S 5/34

(54) **Fixed wavelength mid infrared laser source with an external cavity**

(30) Priority: 25.07.2007 US 828242
(71) Applicant: Daylight Solutions, Inc., Poway, CA 92064 (US)
(72) Inventor: Arnone, David F., Mountain View, CA 94043 (US); Day, Timothy, Poway, CA 92064 (US)
(74) Representative: Viering, Jentschura & Partner

(57) **Abstract**

A MIR laser source (10) that produces a fixed frequency output beam that is within the MIR range includes a QC gain media (14), and a wavelength dependent ("WD") feedback assembly (24) that is spaced apart from the QC gain media (14) and that cooperates with the QC gain media to form an external cavity. The WD feedback assembly (24) may be used to precisely tune and control a lasing wavelength of the external cavity, and the position of the WD feedback assembly relative to the QC gain media may be fixed to maintain the precise lasing wavelength of the external cavity. With this design, each MIR laser source can be individually tuned to achieve the desired fixed frequency output beam that is within the MIR range. The WD feedback assembly (24) may comprise a diffraction grating (24A) on a separate mount (224E) having a flexible part (224J) and a screw (224C) for adjusting the fixed position of the grating.

## Description

### BACKGROUND OF THE INVENTION

Mid Infrared ("MIR") laser sources that produce a fixed wavelength beam can be used in many fields such as, in medical diagnostics, pollution monitoring, leak detection, analytical instruments, homeland security and industrial process control. For example, MIR laser sources can be used in the detection of certain molecules found in human breath that correlate to existing health problems such as asthma, kidney disorders and renal failure.

One type of fixed wavelength, MIR laser source is commonly referred to as Distributed Feedback ("DFB") and includes a quantum cascade ("QC") gain media, and a periodic grating either on the surface of the QC gain media or close to the active region of the QC gain media. The periodic grating on the QC gain media preferentially favors certain laser modes. This results in a MIR laser source having a fixed wavelength beam.

Commonly, the periodic grating is grown using the same methods used to grow the QC gain media. Unfortunately, none of the methods used to grow the periodic grating on the QC gain media are completely precise. For example, if it desired that the MIR laser source have a fixed wavelength of 9.25 microns, a large number of the MIR laser sources may have to be grown until one of these MIR laser sources has a fixed wavelength of 9.25 microns. Stated in another fashion, because of the imprecise growing methods, many of manufactured MIR laser sources will have a fixed wavelength that is different than the desired wavelength. Thus, the yield of this process is low and the process is inefficient and expensive.

It should be noted that DFB laser sources are tunable to a small degree by changing the temperature of the laser gain medium either by external temperature control or by variation of the input current to the QC gain media. Thus, while such laser devices are generally referred to as "fixed" wavelength, it is understood that only a relatively small variation of wavelength is nevertheless available (typically less than 1 % of the peak wavelength) by means of temperature control. Unfortunately, this small tuning range is often not sufficient to achieve the desired fixed wavelength because of the imprecise manufacturing methods.

### SUMMARY OF THE INVENTION

Embodiments of the present invention are directed towards a MIR laser source that produces a fixed frequency output beam that is within the MIR range. In one embodiment, the MIR laser source includes a QC gain media, and a wavelength dependent ("WD') reflector that is spaced apart from the QC gain media and that cooperates with the QC gain media to form an external cavity. By configuring a WD reflector to form an external cavity, control of the wavelength of the output beam may be gained. In this embodiment, the WD reflector is used to precisely tune a lasing wavelength of the external cavity, and the position of the WD reflector relative to the QC gain media is fixed to maintain the precise lasing wavelength of the external cavity. As a result thereof, in certain embodiments, each MIR laser source can be individually tuned with the WD reflector to have desired fixed frequency output beam that is within the MIR range. Stated in another fashion, with the individual tuning of the WD reflector, the manufacturing process used to make this MIR laser source may be very precise. Further, relatively large adjustments to the lasing wavelength can occur without adjusting the QC gain media. This results in a high production yield, and ultimately a relatively inexpensive MIR laser source.

Additionally, in certain embodiments, the MIR laser source is designed to be relatively small, portable, rugged and battery-powered. As a result thereof, the MIR laser source can be easily used in remote locations.

As used herein, to be classified as a MIR laser source, the output beam of the MIR laser source has a wavelength in the range of approximately 3-14 microns. Stated in another fashion, as used herein, the MIR range is approximately 3-14 microns. These MIR laser sources are particularly useful in absorption spectroscopy applications since many gases of interest have their fundamental vibrational modes in the MIR range and thus present strong, unique absorption signatures within the MIR range.

In one embodiment, the MIR laser source includes a rigid, one-piece mounting base that maintains the position of the WD reflector relative to the QC gain media. With this design, the MIR laser source is relatively rugged and relatively easy to manufacture.

Additionally, in some embodiments, the MIR laser source can include a cavity optical assembly positioned between the QC gain media and the WD reflector, that is also fixedly secured to the mounting base so that the mounting base maintains the relative position of the QC gain media, the cavity optical assembly, and the WD reflector. In this embodiment, the cavity optical assembly collimates and focuses the light that passes between the QC gain media and the WD reflector. In certain embodiments, the cavity optical assembly includes a relatively small lens to facilitate the small form factor of the MIR laser source disclosed herein.

Further, in some embodiments, the MIR laser source can include a temperature controller that is in thermal communication with the mounting base. In this embodiment, the temperature controller controls the temperature of the mounting base and the QC gain media. As a result of the integrated temperature controller, the MIR laser source can be used in remote locations away from external cooling sources.

Moreover, in one embodiment, the MIR laser source includes a battery that powers the QC gain media. With this design, the MIR laser source can be made to be extremely portable.

One non-exclusive example of a suitable WD reflector is a diffraction grating. Other suitable examples are discussed in the description section.

Additionally, in some embodiments, the WD reflector can include a reflector retainer that retains the diffraction grating and that allows the diffraction grating to selectively move relative to the QC gain media, and a reflector lock that selectively locks the position of the diffraction grating relative to the QC gain media. For example, the element lock can include a threaded member that moves the diffraction grating relative to the QC gain media and that selectively locks the position of the diffraction grating relative to the QC gain media.

In another embodiment, the fixed frequency, MIR laser source includes a rigid, one piece mounting base, a QC gain media, a battery that is electrically connected to the QC gain media, a cavity optical assembly, and a WD reflector. In this embodiment, the QC gain media, the cavity optical assembly, and the WD reflector are spaced apart from each other and are fixedly secured to the mounting base in a fixed orientation. In this embodiment, the WD reflector is again used to precisely and individually tune the lasing wavelength of the external cavity. The resulting MIR laser source is relatively inexpensive to manufacture, relatively small, lightweight, portable, and rugged.

Embodiments of the present invention are also directed to methods for generating a fixed frequency, output beam that is within the MIR range. In one embodiment, the method includes the steps of providing a rigid mounting base, fixedly securing a QC gain media to the mounting base, positioning a WD reflector spaced apart from the QC gain media, tuning a lasing wavelength of the external cavity with the WD reflector, and fixedly securing the WD reflector to the mounting base.

### BRIEF DESCRIPTION OF THE DRAWINGS

The novel features of embodiments of the present invention, as well as the invention itself, both as to its structure and its operation, will be best understood from the accompanying drawings, taken in conjunction with the accompanying description of certain embodiments, in which similar reference characters refer to similar parts, and in which:

Figure 1 is simplified side illustration, in partial cut-away of a MIR laser source according to an embodiment of the present invention;

Figure 2A is a perspective view, and Figures 2B and 2C are alternative side views of a WD feedback assembly according to an embodiment of the present invention;

Figure 3 is simplified side illustration, in partial cut-away of a MIR laser source according to another embodiment of the present invention; and

Figures 4A-4E are alternative illustrations of a WD feedback assembly according to an embodiment of the present invention;

Figure 5 is simplified side illustration, in partial cut-away of a MIR laser source according to another embodiment of the present invention;

Figures 6 - 8 are side views of WD feedback assemblies according to additional embodiments of the present invention; and

Figure 9 is a perspective view of still another WD feedback assembly according to another embodiment of the present invention.

### DETAILED DESCRIPTION OF THE CERTAIN EMBODIMENTS

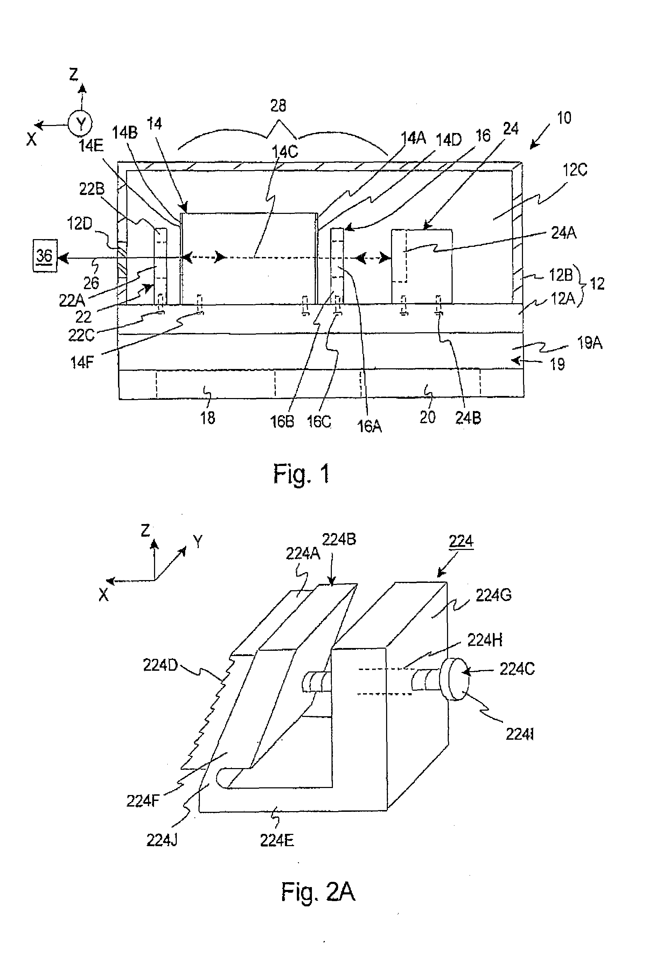

Figure 1 illustrates a MIR laser source 10 according to an embodiment of the present invention that includes a source frame 12, a quantum cascade ("QC") gain media 14, a cavity optical assembly 16, a power source 18 (illustrated in phantom), a temperature controller 19, a laser electronic controller 20 (illustrated in phantom), an output optical assembly 22, and a wavelength dependant ("WD") feedback assembly 24 that cooperate to generate a fixed, output beam 26 that is in the MIR range. The design of each of these components can be varied pursuant to the teachings provided herein. In should be noted that the MIR laser source 10 can be designed with more or fewer components than described above.

As an overview, in certain embodiments, the WD feedback assembly 24 includes a wavelength dependent ("WD") reflector 24A (illustrated in phantom) that cooperates with the QC gain media 14 to form an external cavity 28, Further, the WD reflector 24A can be tuned to adjust the lasing frequency of the external cavity 28 and the wavelength of the output beam 26, and the relative position of the WD feedback assembly 24 and QC gain media 14 can be fixedly maintained so that the laser source 10 produces a precise, fixed wavelength MIR, output beam 26. Stated in another fashion, the feedback assembly 24 can be tuned' (without changing the QC gain media 14) to achieve the desired wavelength of the output beam 26 within the MIR range. This results in a high production yield, and ultimately a relatively inexpensive to make MIR laser source 10.

In alternative, non-exclusive embodiments, the WD reflector 24A can be used to control the fixed wavelength of output beam 26 within the MIR range to within approximately 0.1, 0.01, 0.001, or 0.0001 microns. As a non-exclusive example, the WD reflector 24A can be adjusted so that the MIR laser source 10 has a fixed output beam 26 of (i) 9.125 microns, (ii) 9.126 microns, (iii) 9.127 microns, (iv) 9.128 microns, (v) 9.129 microns, (vi) 9.130 microns, or any other specific wavelength in the MIR range.

In certain embodiments, with the designs provided herein, the output beam 26 has a relatively narrow line width. In non-exclusive examples, the MIR laser source 10 can be designed so that the line width of the output beam 26 is less than approximately 5, 4, 3, 2, 1, 0.8, or 0.5 cm-1.

Further, in certain embodiments, because of the unique design disclosed herein, the MIR laser source 10 can be relatively stable, rugged, small, portable, and self contained source of MIR light.

A number of Figures include an orientation system that illustrates an X axis, a Y axis that is orthogonal to the X axis and a Z axis that is orthogonal to the X and Y axes. It should be noted that these axes can also be referred to as the first, second and third axes.

The source frame 12 supports at least some of the components of the laser source 10. In one embodiment, (i) the QC gain media 14, the cavity optical assembly 16, the output optical assembly 22, and the WD feedback assembly 24 are each fixedly secured, in a rigid arrangement to the source frame 12; and (ii) the source frame 12 maintains these components in precise mechanical alignment to achieve the desired wavelength of the output beam 26.

Additionally, in Figure 1, the power source 18, the temperature controller 19, and the laser electronic controller 20 are fixedly secured to the source frame 12. With this design, all of the critical components are fixed to the source frame 12 in a stable manner, and the laser source 10 can be self-contained and extremely portable. Alternatively, for example, the power source 18, the temperature controller 19, and/or the laser electronic controller 20 can be separate from and external to the source frame 12.

The design of the source frame 12 can be varied to achieve the design requirements of the laser source 10. In Figure 1, the source frame 12 includes a mounting base 12A, and a cover 12B. Alternatively, for example, the source frame 12 can be designed without the cover 12B and/or can have a configuration different from that illustrated in Figure 1.

The mounting base 12A provides a rigid platform for fixedly mounting the QC gain media 14, the cavity optical assembly 16, the output optical assembly 22 and the WD feedback assembly 24. In Figure 1, the mounting base 12A is illustrated as being generally rectangular plate shaped. In one embodiment, the mounting base 12A is a monolithic structure that provides structural integrity to the MIR laser source 10. Alternatively, the mounting base 12 can have a configuration that is different than that illustrated in Figure 1.

In certain embodiments, the mounting base 12A is made of rigid material that has a relatively high thermal conductivity. In one non-exclusive embodiment, the mounting base 12A has a thermal conductivity of at least approximately 170 watts/meter K. With this design, in addition to rigidly supporting the components of the MIR laser source 10, the mounting base 12A also readily transfers heat away from the QC gain media 14 to the temperature controller 19. For example, the mounting base 12A can be fabricated from a single, integral piece of copper, copper-tungsten or other material having a sufficiently high thermal conductivity. The one piece structure of the mounting base 12A maintains the fixed relationship of the components mounted thereto and contributes to the small size and portability of the MIR laser source 10.

The cover 12B is secured to the mounting base 12A, and the cover 12B cooperates with the mounting base 12A to define a cover cavity 12C and form a housing that encloses and protects the-QC gain media 14, the cavity optical assembly 16, the output optical assembly 22 and the WD feedback assembly 24. In Figure 1, the cover 12B is shaped somewhat similar to an inverted, open rectangular box. Additionally, the cover 12B can include a transparent window 12D that allows the output beam 26 to pass through the cover 12B.

Additionally, the cover 12B can include a cover fastener (not shown) that secures the cover 12B to the mounting base 12A. For example, the cover fastener can include one or more threaded bolts, an adhesive, one or more clamps, solder, or a weld.

In one embodiment, the cover 12B is hermetically sealed to the mounting base 12A in an air tight manner. This allows the source frame 12 to provide a controlled environment around some of the components of the laser source 10. For example, the cover cavity 12C can be filled with a fluid such as nitrogen or an air/nitrogen mixture to keep out moisture and humidity; or the cover cavity 12C can be subjected to a vacuum.

In certain embodiments, the overall size of the source frame 12 is quite small so that the laser source 10 is very portable. For example, the source frame 12 can have dimensions of approximately 20 centimeters (height) by 20 centimeters (width) by 20 centimeters (length) (where length is taken along the propagation direction of the laser beam) or less, and more preferably, the source frame 12 has dimensions of approximately 3 centimeters (height) by 4 centimeters (width) by 5 centimeters (length). Still alternatively, the source frame 12 can have dimensions of less than approximately 10 millimeters (height) by 25 millimeters (width) by 30 millimeters.

The QC gain media 14 is a unipolar semiconductor laser that includes a series of energy steps built into the material matrix while the crystal is being grown. With this design, electrons transmitted through the QC gain media 14 emit one photon at each of the energy steps. In one embodiment, the QC gain media uses two different semiconductor materials such as InGaAs and AlInAs (grown on an InP or GaSb substrate for example) to form a series of potential wells and barriers for electron transitions. The thickness of these wells/barriers determines the wavelength characteristic of the QC gain media 14. Fabricating QC gain media of different thickness enables production of MIR laser having different output frequencies within the MIR range.

It should be noted that fine tuning of the output beam 26 may be achieved by controlling the temperature of the QC gain media 14, such as by changing the DC bias current. Such temperature tuning is relatively narrow and may be used to vary the wavelength by approximately 1-2 gigahertz/Kelvin which is typically less than 0.01% of the peak emission wavelength.

In the case of QC gain media 14, the "diode" has been replaced by a conduction band quantum well. Electrons are injected into the upper quantum well state and collected from the lower state using a superlattice structure. The upper and lower states are both within the conduction band. Replasing the diode with a single-carrier quantum well system means that the generated photon energy is no longer tied to the material bandgap. This removes the requirement for exotic new materials for each wavelength, and also removes Auger recombination as a problem issue in the active region. The superlattice and quantum well can be designed to provide lasing at almost any photon energy that is sufficiently below the conduction band quantum well barrier.

As used herein the term QC gain media 14 shall also include Interband Cascade Lasers (ICL), ICL lasers use a conduction-band to valence-band transition as in the traditional diode laser.

In Figure 1, the QC gain media 14 includes (i) a first facet 14A that faces the cavity optical assembly 16 and the WD feedback assembly 24, and (ii) a second facet 14B that faces the output optical assembly 22. In this embodiment, the QC gain media 14 emits from both facets 14A, 14B.

In one embodiment, the first facet 14A is coated with an anti-reflection ("AR") coating 14D and the second facet 14B is coated with a reflective coating 14E. The AR coating 14D allows light directed from the QC gain media 14 at the first facet 14A to easily exit the QC gain media 14 and allows the light reflected from the WD feedback assembly 24 to easily enter the QC gain media 14. In contrast, the reflective coating 14E reflects at least some of the light that is directed at the second facet 14B from the QC gain media 14 back into the QC gain medium 14. In one non-exclusive embodiment, the AR coating 14D can have a reflectivity of less than approximately 2 percent, and the reflective coating 14E can have a reflectivity of between approximately 2-95 percent. In this embodiment, the reflective coating 14E acts as an output coupler for the external cavity 28.

In one embodiment, the QC gain media 14 is approximately 2 millimeters by 0.5 millimeters, by 90 microns. Further, the QC gain media 14 can include a media fastener 14F that fixedly secures the QC gain media 14 to the mounting base 12A. For example, the media fastener 14F can include one or more threaded bolts, an adhesive, one or more clamps, solder, or a weld.

A suitable QC gain media 14 can be purchased from Alpes Lasers, located in Switzerland, Maxion Technologies, Inc., located in Maryland, US and Hamamatsu located in Japan.

The QC gain media 14 generates a relatively strong output IR beam and also generates quite a bit of heat. Accordingly, the temperature controller 19 can be an important component that is needed to remove the heat, thereby permitting long lived operation of the laser source 10.

The cavity optical assembly 16 is positioned between the QC gain media 14 and the WD feedback assembly 24 along the lasing axis 14C (along the X axis in Figures), and collimates and focuses the light that passes between these components. For example, the cavity optical assembly 16 can include one or more lens 16A (one is illustrated in phantom), a lens mount 16B and a lens fastener 16C.

For example, the lens 16A can be an aspherical lens having an optical axis that is aligned with the lasing axis 14C. In one embodiment, to achieve the desired small size and portability, the lens 16A has a relatively small diameter. In alternative, non-exclusive embodiments, the lens 16A has a diameter of less than approximately 5 or 10 millimeters, and a focal length of approximately 1, 2, 3, 4, 5,6, 7, 8, 9, 10,11,12,13,14, 15, 16, 17, 18, 19, or 20 mm and any fractional values thereof. The lens 16A can comprise materials selected from the group of Ge, ZnSe, ZnS Si, CaF, BaF or chalcogenide glass. However, other materials may also be utilized. The lens 16A may be made using a diamond turning or molding technique. The lens 16A can be designed to have a relatively large numerical aperture (NA). For example, the lens 16A can have a numerical aperture of at least approximately 0.6, 0.7, or 0.8. The NA may be approximated by the lens diameter divided by twice the focal length. Thus, for example, a lens diameter of 5 mm having aNA of 0.8 would have a focal length of approximately 3.1 nm.

The lens mount 16B fixedly and rigidly retains the lens 16A. For example, the lens mount 16B can be a rigid bracket. The lens fastener 16C fixedly and rigidly secures the lens mount 16B and the lens 16A to the mounting base 12A. For example, the lens fastener 16C can include one or more threaded bolts, an adhesive, one or more clamps, solder, or a weld.

The power source 18 provides electrical power for the QC gain media 14, the laser electronic controller 20, and the temperature controller 30. In Figure 1, the power source 18 is a battery that is secured to the source frame 12. For example, the battery can be nickel metal hydrate. Alternatively, the power source 18 can be external to the source frame 12. For example, the power source 18 can be an external battery or a power outlet.

The temperature controller 19 can be used to control the temperature of the QC gain media 14, the mounting base 12A, and/or one or more of the other components of the laser assembly 12. Further, the temperature controller 19can be used to maintain the relative position of the QC gain media 14, the optical assemblies 16, 22 and the WD feedback assembly 24.

In one embodiment, the temperature controller 19 includes a thermoelectric cooler 19A and a temperature sensor (not shown). The thermoelectric cooler 19A may be controlled to effect cooling or heating depending on the polarity of the drive current thereto. In Figure 1, the thermoelectric cooler 19A is fixed to the bottom of the mounting base 12A so that the thermoelectric cooler 19A is in direct thermal communication with the mounting base 12A, and so that the thermoelectric cooler 19A can provide additional rigidity and support to the mounting base 12A, In one embodiment, the top of the thermoelectric cooler 19A is approximately the same size as the bottom surface of the mounting base 12A. This promotes good heat transfer between the thermoelectric cooler 19A and the mounting base 12A, and maximizes the support for the mounting base 12A provided by the thermoelectric cooler 19A. The thermoelectric cooler 19A can be fixedly secured to the mounting base 12A with bolts, epoxy, welding, solder or other suitable means.

Alternatively, an intermediate plate may be attached between the thermoelectric cooler 19A and the mounting base 12A.

In certain embodiments, the temperature controller 19 can be used to change the temperature of the laser source 10 to affect a relatively small wavelength tuning range on the order 0.01 % or less.

The temperature sensor provides temperature information that can be used to control the operation of the thermoelectric cooler 19A so that the thermoelectric cooler 19A can maintain the desired temperature of the MIR laser source 10. The temperature sensor 10 may comprise an encapsulated integrated circuit with a thermistor as the temperature sensor active component. The temperature sensor can be positioned on the mounting base 12A near the QC gain media 14 and can be used to monitor the temperature of the QC gain media 14.

Additionally, or alternatively, the source frame 12 can be mounted to a heat sink (not shown) inside a larger housing (not shown) which may also contain additional equipment including cooling fans and vents to further remove the heat generated by the operation of the laser source 10.

The laser electronic controller 20 controls the operation of the MIR laser source 10 including the electrical power that is directed to the QC gain media 14 and the temperature controller 19. For example, the laser electronic controller 20 can include a processor that controls QC gain media 14 by controlling the electron injection current. In Figure 1, the laser electronic controller 20 is rigidly and fixedly mounted to the source frame 12 so that the laser source 10 is portable and rugged. Alternatively, for example, the laser electronic controller 20 can be external to the source frame 12.

The output optical assembly 22 is positioned between the QC gain media 14 and the window 12D in line with the lasing axis 14C; and the output optical assembly 22 collimates and focuses the light that exits the second facet 14B of the QC gain media 14. For example, the output optical assembly 22 can include one or more lens 22A (one is illustrated in phantom), a lens mount 22B and a lens fastener 22C.

The lens 22A can be somewhat similar in design to the lens 16A of the cavity optical assembly 16. The lens mount 22B fixedly and rigidly retains the lens 22A. For example, the lens mount 22B can be a rigid bracket. The lens fastener 22C fixedly and rigidly secures the lens mount 22B and the lens 22A to the mounting base 12A. For example, the lens fastener 22C can include one or more threaded bolts, an adhesive, one or more clamps, solder, or a weld.

The WD feedback assembly 24 reflects the light back to the QC gain media 14 along the lasing axis 14C, and is used to precisely adjust the lasing frequency of the external cavity 28 and the wavelength of the output beam 26. Stated in another fashion, the WD feedback assembly 24 is used to feed back to the QC gain media 14 a relatively narrow band wavelength which is then amplified in the QC gain media 14. In this manner, the output beam 26 may be tuned and set to a desired fixed wavelength with the WD feedback assembly 24 without adjusting the QC gain media 14. Thus, in the external cavity 28 arrangements disclosed herein, the WD feedback assembly 24 dictates what wavelength will experience the most gain and thus dominate the wavelength of the output beam 26.

As provided above, the WD feedback assembly 24 includes the WD reflector 24A that has wavelength dependent reflectivity. The design of the WD reflector 24A and the WD feedback assembly 24 can vary pursuant to the teachings provided herein. Non-exclusive examples of a suitable WD reflector 24A includes a diffraction grating, a MEMS grating, prism pairs, a thin film filter stack with a reflector, an acoustic optic modulator, or an electro-aptic modulator. A more complete discussion of these types of WD reflectors 24A can be found in the Tunable Laser Handbook, Academic Press, Inc., Copyright 1995, chapter 8, Pages 349-435, Paul Zorabedian.

The WD reflector 24A is spaced apart from the QC gain media 14 and cooperates with the QC gain media 14 to form the external cavity 28. In this embodiment, the external cavity 28 extends from the output coupler (reflective coating 14E) to the WD reflector 24A. The term external cavity 28 is utilized to designate the WD reflector 24A positioned outside of the QC gain media 14. In Figure 1, the external cavity 28 is not external to the source frame 12 in which the QC gain media 14 is contained. Instead, in Figure 1, the external cavity 28 is contained within the source frame 12.

The type of adjustment done to the WD reflector 24A to adjust the lasing frequency of the external cavity 28 and the wavelength of the output beam 26 will vary according to the type of WD reflector 24A. For example, if the WD reflector 24A is a diffraction grating, rotation of the diffraction grating relative to the lasing axis 14C and the QC gain media 14 adjusts the lasing wavelength and the wavelength of the output beam 26. There are many different ways to precisely rotate and fix the position of the diffraction grating. Only a few, non-exclusive examples are illustrated and discussed in detail herein.

Additionally, as illustrated in Figure 1, the WD feedback assembly 24 includes a feedback fastener 24B that fixedly and rigidly secures the WD feedback assembly 24 to the mounting base 12A. For example, the feedback fastener 24B can include one or more threaded bolts, an adhesive, one or more clamps, solder, or a weld.

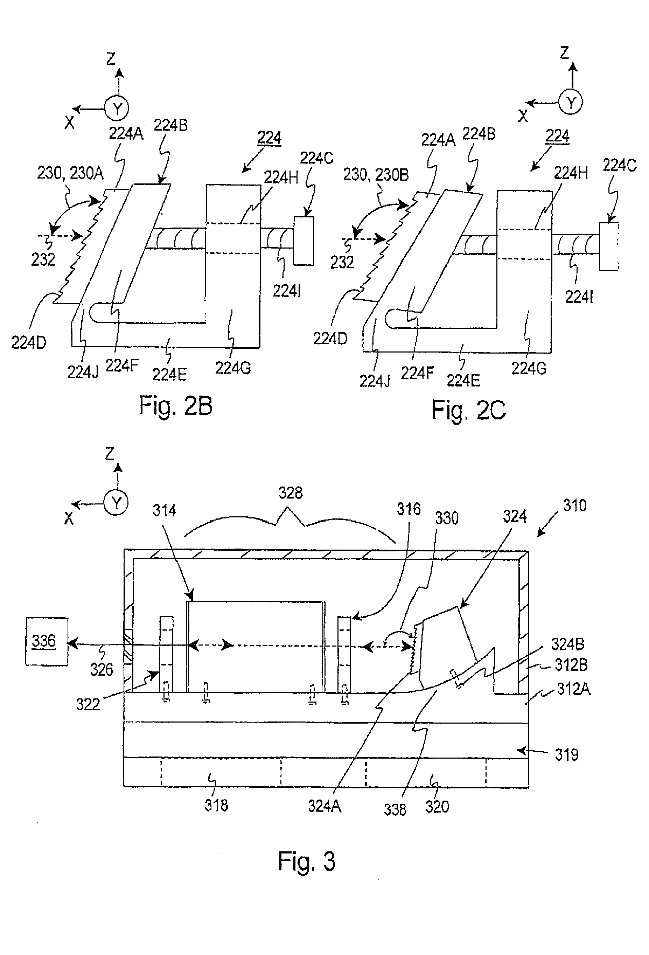

Figure 2A is a perspective view, and Figures 2B and 2C are alternative side views of one embodiment of a WD feedback assembly 224 that can be used in the laser source 10 of Figure 1. In this embodiment, WD feedback assembly 224 includes a WD reflector 224A, a reflector retainer 224B, and a reflector lock 224C.

In the embodiment illustrated in Figure 2A-2C, the WD reflector 224A is a diffraction grating that includes a glass or polished metal reflector surface 224D having a large number of very fine parallel grooves or slits. With this design, rotation of the reflector surface 224D relative to the QC gain media 14 (illustrated in Figure 1) and the incident beam 232 changes the angle of incidence 230 of the beam 232 onto the reflector surface 224D and the wavelength of the light. Stated in another fashion, the reflector surface 224D is selectively movable relative to the QC gain media 14 to precisely adjust the lasing wavelength of the external cavity 28 (illustrated in Figure 1).

In this embodiment, changing the incidence angle 230 serves to preferentially select a single wavelength which is the first order diffracted light from the reflector surface 224D. This light is diffracted back onto the same path as the incident beam 232 to thereby tune the external cavity 28 to the diffracted wavelength. The diffracted laser light is received by the QC gain media 14 to provide stimulated laser emission thereby resonating the QC gain media 14 with the grating selected wavelength.

The reflector retainer 224B (i) retains the WD reflector 224A, (ii) allows for rotation of the reflector surface 224D relative to the incident beam 232, and the QC gain media 14, and (iii) secures the WD reflector 224A to the mounting base 12A (illustrated in Figure 1). The design and attachment of the reflector retainer 224B can vary. Figures 2A-2C illustrate one, non-exclusive embodiment of the reflector retainer 224B, In this embodiment, the reflector retainer 224B includes a retainer base 224E, a retainer plate 224F, and a fixed plate 224G that are arranged so that the reflector retainer 224B is shaped somewhat similar to a truncated right triangle.

In one embodiment, the retainer base 224E is generally rectangular plate shaped and is fixedly secured to the mounting base 12A with the feedback fastener 24B (illustrated in Figure 1). Further, the retainer plate 224F directly retains the WD reflector 224A. In Figures 2A-2C, the retainer plate 224F is generally rectangular plate shaped and cantilevers upward from the retainer base 224E at an acute angle. Additionally, the intersection of the retainer plate 224F and the retainer base 224E functions as a flexural pivot 224J and can include a cut-out that allows the retainer plate 224F to pivot relative to the retainer base 224E. Moreover, in this embodiment, the fixed plate 224G is generally rectangular plate shaped and cantilevers upward from the retainer base 224E at approximately a right angle.

In Figures 2A-2C, the reflector retainer 224B is made of a single piece of material. Non-exclusive examples of suitable materials for the reflector retainer 224B include aluminum and copper. Alternatively, for example, the retainer plate 224F can be secured to the retainer plate 224F with a hinge or another type of pivot that allows for pivoting of the retainer plate 224F relative to the rest of the reflector retainer 224A. In one embodiment, the retainer plate 224F is biased to pivot towards the fixed plate 224G.

The reflector lock 224C can be used to selectively move the retainer plate 224F and the WD reflector 224A relative to the other components of the laser source 10 and to selectively inhibit relative movement between the WD reflector 224A and the QC gain media 14. In Figures 2A-2C, the reflector lock 224C includes an internally threaded surface 224H (illustrated as dashed lines) in the fixed plate 224G and an externally threaded member 2241 (e.g. a bolt) that threads into the internally threaded surface 224H. In this embodiment, the bolt 224I includes a distal end that engages the back of the retainer plate 224F, and proximal head that can be rotated by a user to pivot the WD reflector 224A. With this design, rotation of the bolt 2241 in one direction causes the flexural pivot 224J to bend and the angle of incidence 230 to decrease, and rotation of the bolt 224I in the opposite direction causes the flexural pivot 224J to bend and the angle of incidence 230 to increase. With this design, the user can finely tune the wavelength of the external cavity 28 separate from the QC gain media 14. In one non-exclusive embodiment, the bolt 224I can be used to rotate the WD reflector 224A approximately five degrees.

Figures 2B and 2C are alternative side views that illustrate the WD reflector 224F at two different angles of incidence 230. More specifically, in Figure 2B, the WD reflector 224F is at a first angle of incidence 230A; and in Figure 2C, the WD reflector 224F is at a second angle of incidence 230B that is different than first angle of incidence 230A. Because of the design of the WD reflector 224F, the lasing frequency of the external cavity 28 is different when the WD reflector 224F is at the first angle of incidence 230A than when the WD reflector 224F is at the second angle of incidence 230B. As a result, in this embodiment, the reflector lock 224C can be used to precisely adjust the wavelength of the output beam 26.

Referring to Figures 1 and 2A, in this embodiment, during manufacturing of the laser source 10, the various components (except the cover 12B) can be fixedly attached to the mounting base 12A. Next, the laser source 10 can be turned on, and a measurement device 36 can be used to precisely measure the wavelength of the output beam 26. Subsequently, the bolt 2241 can be rotated until the laser source 10 generates the desired fixed wavelength output beam 26. Finally, the cover 12B can be secured to the mounting base 12A. Alternatively, the laser source 10 could be designed so that the WD reflector 24A can be rotated with the cover 12B secured to the mounting base 12A.

Figure 3 is a simplified illustration of another embodiment of the laser source 310 that includes a QC gain media 314, a cavity optical assembly 316, a power source 318, a temperature controller 319, a laser electronic controller 320, an output optical assembly 322 that are similar to the corresponding components described above. However, in this embodiment, the mounting base 312A and the WD feedback assembly 324 are slightly different. More specifically, in this embodiment mounting base 312A includes a curved region 338 (exaggerated for clarity).

Further, in Figure 3, the WD feedback assembly 324 includes a WD reflector 324A (e.g. a diffraction grating) and a fixed reflector retainer 324B. In this embodiment, the location of where the WD feedback assembly 324 is mounted along the curved region 338 will determine the angle of incidence 330, the lasing wavelength of the external cavity 328, and the fixed wavelength of the output beam 326.

In this embodiment, during manufacturing of the laser source 310, the various components, except the cover 312B and the WD feedback assembly 324, are fixedly attached to the mounting base 312A. However, the WD feedback assembly 324 is positioned adjacent to the curved region 338, Next, the laser source 310 is turned on, and a measurement device 336 is used to precisely measure the wavelength of the output beam 326. Subsequently, the WD feedback assembly 324 is moved along the curved region 338 until the laser source 310 generates the desired fixed wavelength output beam 326. Next, the WD feedback assembly 324 is fixed to the mounting base 312A. Finally, the cover 312B can be secured to the mounting base 312A.

In Figure 3, the WD feedback assembly 324 is positioned on the curved region 338 and allowed to move along the curved region 338 during the tuning of the laser source 310. In this embodiment, the WD feedback assembly 324 is locked to the mounting base 312A with the mechanical clamp 324B (such as a bolt or clamp) or an adhesive or weld.

In certain embodiments, the curved region 338 has a center of curvature at the intersection of the lasing axis and the grating face.

It should be noted that the processes used to the manufacture the laser sources disclosed herein can be performed manually or in an automated assembly process. For example, the laser sources disclosed herein can be tuned with a robot, a human or a combination thereof.

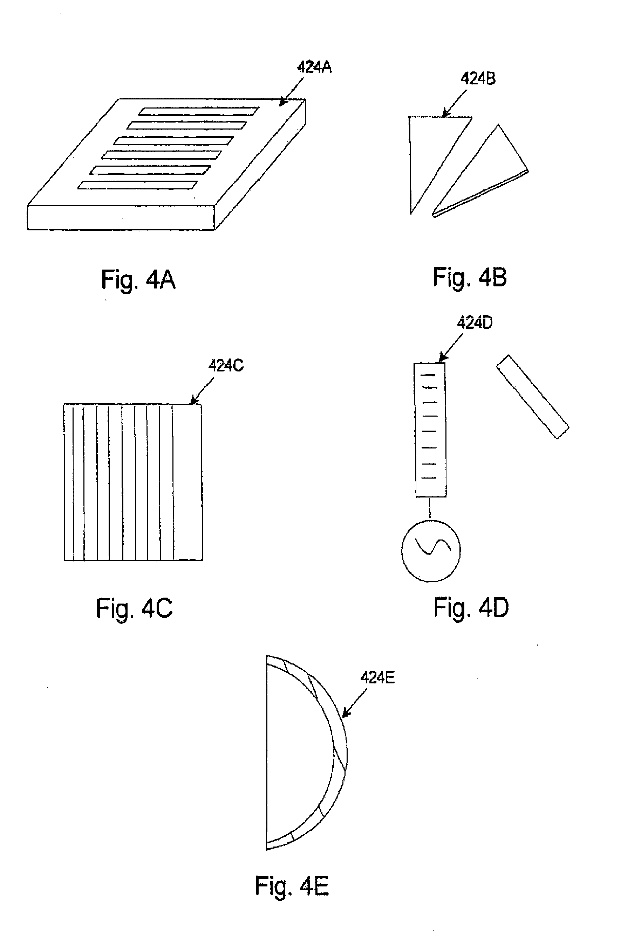

Figures 4A-4E illustrate alternative embodiments other WD feedback reflectors. More specifically, Figure 4A is a simplified illustration of a MEMS grating 424 that can be used as the WD reflector. In this embodiment, changing a voltage applied to the MEMS grating adjusts the lasing wavelength and the wavelength of the output beam 26 (not shown in Figure 4A).

Figure 4B is a simplified side illustration of a pair of prisms 424B that can be used as the WD reflector. In this embodiment, the prisms can be moved relative to each other to adjust the lasing wavelength and the wavelength of the output beam 26 (not shown in Figure 4B).

Figure 4C is a simplified side illustration of a thin film filter stack with a reflector 424C that can be used as the WD reflector. In this embodiment, the filter stack is designed to transmit the desired wavelength to the reflector.

Figure 4D is a simplified illustration of an acoustic optic modulator 424D that can be used as the WD reflector. In this embodiment, the RF field is changed to adjust the lasing wavelength and the wavelength of the output beam 26 (not shown in Figure 4D).

Figure 4E is a simplified cut-way illustration of a parabolic diffraction grating 424E that can be used as the WD reflector. In this embodiment, grating 424E can be rotated to adjust the lasing wavelength. Further, in certain embodiments, with a parabolic grating 424E, the cavity optical assembly 16 (illustrated in Figure 1) may not be necessary.

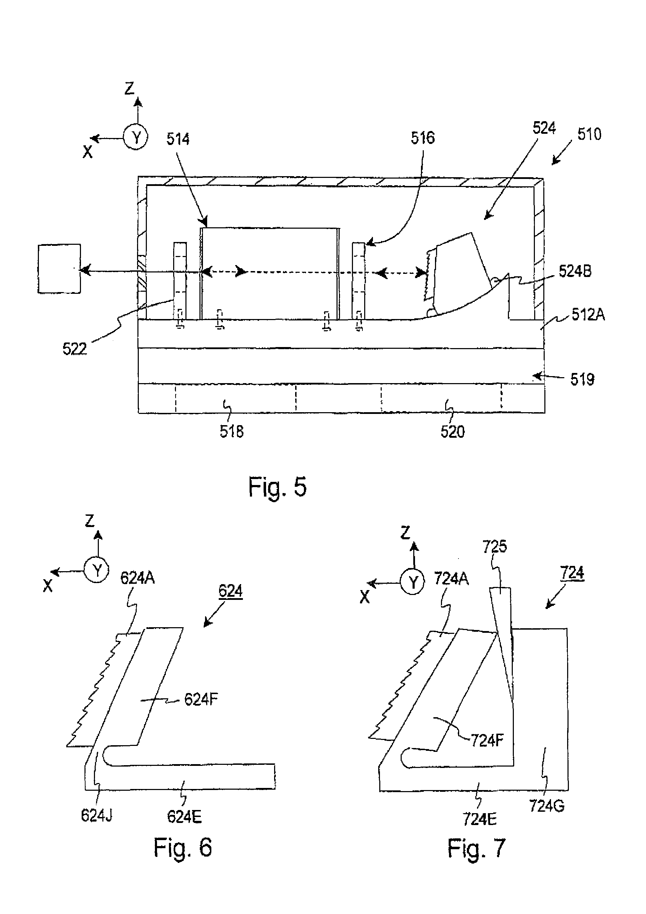

Figure 5 is a simplified illustration of another embodiment of the laser source 510 that includes a mounting base 512A, a QC gain media 514, a cavity optical assembly 516, a power source 518, a temperature controller 519, a laser electronic controller 520, an output optical assembly 522, and a WD feedback assembly 524 that are similar to the corresponding components described above and illustrated in Figure 3. However, in this embodiment, the WD feedback assembly 524 is fixed to the mounting base 512A with an adhesive 524B that is outside the compressive stack.

Figure 6 is a side view of another embodiment of a WD feedback assembly 624 that can be used in the laser source 10 of Figure 1. In this embodiment, WD feedback assembly 624 again includes a WD reflector 624A, a retainer base 624E and a retainer plate 624Fthat form the flexural pivot 624J. In this embodiment, the lasing wavelength of the external cavity can be adjusted by moving the retainer plate 624F and the WD reflector 624A and permanently deforming the flexural pivot 624J. For example, the flexural pivot 624J can be permanently deformed with a pry bar or by selectively heating portions of the flexural pivot 624J for example.

Figure 7 is a side view of another embodiment of a WD feedback assembly 724 that can be used in the laser source 10 of Figure 1. In this embodiment, WD feedback assembly 724 again includes a retainer base 724E, a fixed plate 724G, a retainer plate 724F and a WD reflector 724A. In this embodiment, the lasing wavelength of the external cavity can be adjusted by moving the retainer plate 724F and the WD reflector 724A with a wedge 725 that is forced between the retainer plate 724F and the fixed plate 724G.

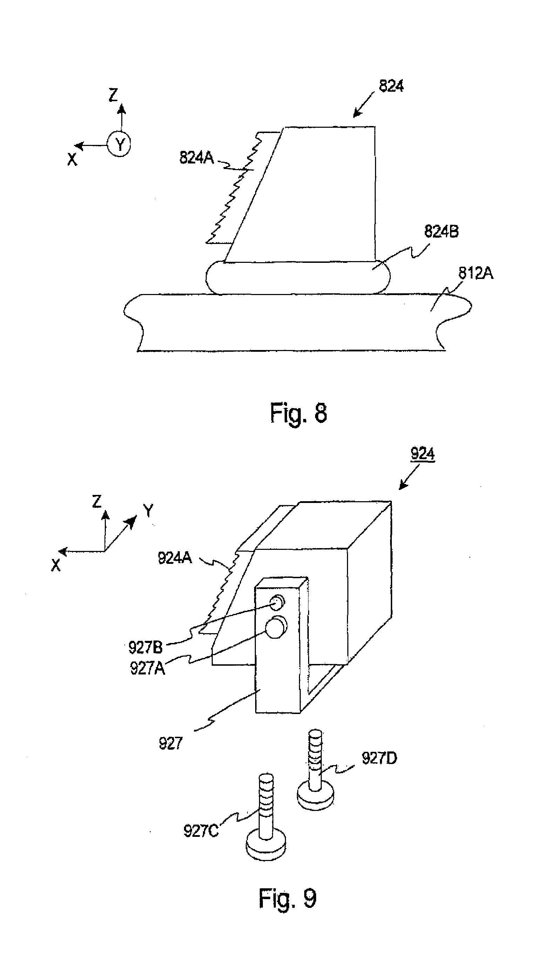

Figure 8 is a side view of another embodiment of a WD feedback assembly 824 and a portion of a mounting base 812A that can be used in the laser source 10 of Figure 1. In this embodiment, WD feedback assembly 824 again includes a WD reflector 824A and a reflector retainer 824B. In this embodiment, the reflector retainer 824B is a pillow of adhesive that mounts the rest of the WD feedback assembly 824 to the mounting base 812A. In this embodiment, the position of the WD reflector 824A can be rotated about the Y axis and about the Z axis during tuning of the laser assembly. For example, the position of the WD reflector 824A can be adjusted prior to the adhesive curing to tune the lasing wavelength and subsequently held in place until the adhesive cures.

Figure 9 is a perspective, partly exploded view of another embodiment of a WD feedback assembly 924. In this embodiment, WD feedback assembly 924 includes a WD reflector 924A, and a retainer bracket 927 that mounts the WD reflector 924A to the mounting base 12A (illustrated in Figure 1). In this embodiment, WD feedback assembly 924 also includes a first pivot 927A that pivotably secures the WD reflector 924A to the retainer bracket 927, and a first lock 927B that selectively locks the WD reflector 924A to the retainer bracket 927. In this design, the first pivot 927A allows the WD reflector 924A to be rotated about the Y axis to adjust the lasing wavelength. Further, in this embodiment, the WD feedback assembly 924 also includes a second pivot 927C that pivotably secures the retainer bracket 927 to the mounting base 12A, and a second lock 927D that selectively locks the retainer bracket 927 to the mounting base 12A. In this design, the second pivot 927C allows the WD reflector 924A to be rotated about the Z axis to align the WD reflector 924A so that the light is directed back into the QC gain media 14 (illustrated in Figure 1). Thus, this design allows for two independent rotational axes for the WD reflector 924A.

While the particular laser sources as shown and disclosed herein is fully capable of obtaining the objects and providing the advantages herein before stated, it is to be understood that it is merely illustrative of the presently preferred embodiments of the invention and that no limitations are intended to the details of construction or design herein shown other than as described in the appended claims.

## Claims

1. A fixed frequency, MIR laser source comprising:
a QC gain media; and
a WD reflector that is spaced apart from the QC gain media, the WD reflector cooperating with QC gain media to form an external cavity, wherein the position of the WD reflector relative to the QC gain media is fixed to maintain a precise lasing wavelength of the external cavity within the MIR range,

2. The MIR laser source of claim 1 further comprising a rigid, one piece mounting base that maintains the position of the WD reflector relative to the QC gain media.

3. The MIR laser source of claim 2 further comprising a cavity optical assembly positioned between the QC gain media and the WD reflector, the cavity optical assembly being secured to the mounting base so that the mounting base maintains the relative position of the QC gain media, the cavity optical assembly, and the WD reflector.

4. The MIR laser source of claim 2 further comprising (i) a temperature controller that is in thermal communication with the mounting base, the temperature controller controlling the temperature of the mounting base and the QC gain media, and (ii) a battery that powers the QC gain media.

5. The MIR laser source of claim 1 wherein the WD reflector includes a diffraction grating; a reflector retainer that retains the grating and that allows the grating to move relative to the QC gain media; and a reflector lock that selectively locks the position of the grating relative to the QC gain media.

6. The MIR laser source of claim 5 wherein the reflector lock includes a threaded member that moves the grating relative to the QC gain media and that selectively locks the position of the grating relative to the QC gain media.

7. The MIR laser source of claim 5 wherein the reflector lock includes a wedge that moves the grating relative to the QC gain media.

8. The MIR laser source of claim 1 wherein the WD reflector includes a diffraction grating, and a reflector retainer that retains the grating; and wherein the reflector retainer is permanently deformed during movement of the grating relative to the QC gain media.

9. The MIR laser source of claim 1 wherein the WD reflector includes a diffraction grating, and an adhesive that maintains the position of the diffraction grating relative to the QC gain media.

10. The MIR laser source of claim 1 wherein the WD reflector includes a diffraction grating, and wherein the diffraction grating is moved along a curved surface to adjust a lasing wavelength of the external cavity.

11. A method for generating a fixed frequency, output beam that is within the MIR range, the method comprising the steps of:
providing a rigid mounting base;
fixedly securing a QC gain media to the mounting base;
positioning a WD reflector spaced apart from the QC gain media, the WD reflector cooperating with the QC gain media to form an external cavity;
adjusting a lasing wavelength of the external cavity with the WD reflector; and
fixedly securing the WD reflector to the mounting base so that the relative position of the WD reflector and the QC gain media is maintained.

12. The method of claim 11 wherein the step of providing a mounting base includes the step of providing a one piece mounting base, and further comprising the step of fixedly securing a cavity optical assembly to the mounting base between the QC gain media and the WD reflector.

13. The method of claim 11 further comprising the steps of controlling a temperature of the mounting base and the QC gain media with a temperature controller that is in thermal communication with the mounting base, and powering the QC gain media with a battery that is secured to the mounting base.

14. The method of claim 11 wherein the step of fixedly securing the WD reflector includes the steps of retaining the WD reflector with a reflector retainer, moving the reflector retainer with a reflector lock, and locking the reflector retainer in position relative to the QC gain media with the reflector lock.

15. The method of claim 11 wherein the step of adjusting a lasing wavelength of the external cavity with the WD reflector includes rotating the WD reflector.
